# EUROPÄISCHE PATENTSCHRIFT

(11) **EP 2 288 573 B1**
(45) Veröffentlichungstag und Bekanntmachung des Hinweises auf die Patenterteilung: **04.11.2020**
(21) Anmeldenummer: 09761542.1
(22) Anmeldetag: 21.04.2009
(51) Int. Cl.: B81C 3/00, G01L 9/00

(54) **HERSTELLUNGSVERFAHREN FÜR EIN MIKROMECHANISCHES BAUELEMENT BESTEHEND AUS EINEM TRÄGER UND EINEM HALBLEITERCHIP**
PRODUCTION METHOD FOR A MICROMECHANICAL COMPONENT, CORRESPONDING COMPOSITE COMPONENT AND CORRESPONDING MICROMECHANICAL COMPONENT
PROCÉDÉ DE RÉALISATION DE COMPOSANT MICRO-MÉCANIQUE, COMPOSITE DE COMPOSANTS CORRESPONDANT ET COMPOSANT MICRO-MÉCANIQUE CORRESPONDANT

(30) Priorität: 09.06.2008 DE 102008002307
(43) Veröffentlichungstag der Anmeldung: 02.03.2011
(73) Patentinhaber: Robert Bosch GmbH, 70442 Stuttgart (DE)
(72) Erfinder: Benzel, Hubert, 72124 Pliezhausen (DE); Henning, Frank, 72770 Reutlingen (DE); Scharping, Armin, 72555 Metzingen (DE); Schelling, Christoph, 70597 Stuttgart (DE)
(86) Internationale Anmeldenummer: PCT/EP2009/054695
(87) Internationale Veröffentlichungsnummer: WO 2009/149979

(56) Entgegenhaltungen:
- WO-A1-2005/040747
- DE-A1-102007 012 106
- US-A- 4 840 067

## Beschreibung

### STAND DER TECHNIK

Die vorliegende Erfindung betrifft ein Herstellungsverfahren für ein mikromechanisches Bauelement, einen entsprechenden Bauelementverbund und ein entsprechendes mikromechanisches Bauelement.

Ohne Beschränkung der Allgemeinheit werden die vorliegende Erfindung und die ihr zugrundeliegende Problematik anhand von Hochdrucksensorelementen erläutert, wobei ein oder mehrere, dünne Siliziumchips mit oder ohne integrierter Auswerteschaltung auf ein Stahlsubstrat mit einer Stahlmembran gelötet sind.

Wie aus der DE 10 2007 012 106 A1 bekannt, liegt die Schaltungs- und Anschlussseite der Siliziumchips dabei auf der der Stahlmembran abgewandten Seite. Als Lot wird beispielsweise ein Glaslot (im Weiteren auch als Sealglas bezeichnet) verwendet. Diese Technologie ist beispielsweise unter dem Namen Pattern-Transfer bekannt. Sie besitzt jedoch verschiedene Herausforderungen hinsichtlich der Prozessierung. So sind mehrere aufwändige Wechsel zwischen Vorderseiten- und Rückseitenbearbeitung der Chips erforderlich. Die Handhabung der dabei verwendeten kleinen bis sehr kleinen Chips ist aufwändig. Es sind mehrere aufwändige Wechsel zwischen Waferprozessen, Einzelchipprozessen (Löten) und Batchprozessen notwendig. Schließlich sind besondere Maßnahmen zur Minimierung von Lunkerbildung beim Löten erforderlich.

Die DE 100 36 284 A1 beschreibt ein Hochdrucksensorelement, bei dem auf einer Membran, von der Membran durch eine elektrisch isolierende Schicht getrennt, mindestens ein Messelement in Form eines Dehnmessstreifens aufgebracht wird. Das Messelement wird auf ein elektrisch isolierendes Substrat aufgebracht, das in einem weiteren Schritt auf der dem Messelement abgewandten Seite an der Membran befestigt wird, sodass das elektrisch isolierende Substrat die elektrisch isolierende Schicht bildet.

Die DE 10 2007 012 106 A1 offenbart einen Drucksensor mit einem Metallgehäuse und einem Halbleiterchip. Das Gehäuse weist eine Membran auf, die einstückig mit dem Gehäuse ist, sowie einen Einlass zum Zuführen eines Fluids zu der Membran.

Die DE 103 50 036 A1 und die DE 10 2005 035 057 A1 beschreiben ein jeweiliges Verfahren zum Herstellen einer Halbleiterchipanordnung, wobei eine Mehrzahl von Halbleiterchips über dünne rückseitige Stege bzw. Stützstellen mit einem Trägersubstrat verbunden ist. Die Stege sind beispielsweise aus Silizium und werden herstellungsbedingt von einem Hohlraum umgeben. Durch einen gegenüber dem Trägersubstrat und den Halbleiterchips selektiven Ätzprozess lassen sich die Stege auflösen und somit die Halbleiterchips vom Trägersubstrat trennen.

Die DE 199 34 114 A1 beschreibt ein Substrat und einen Werkstückträger zur Aufnahme einer Mehrzahl derartiger Substrate, um einen Substratverbund zu bilden.

Aus der US 4 840 67 A ist ein Halbleiterdrucksensor mit einem Stahlsubstrat bekannt. Dabei wird auf eine Membran des Stahlsubstrats eine Oxidschicht erzeugt, auf dem mittels einer bei niedrigen Temperaturen schmelzenden Glasschicht ein Halbleiterchip zur Erfassung der Durchbiegung der Membran aufgebondet wird.

Aus der WO 2005/040747 A1 ist ein Herstellungsverfahren für Halbleiterdrucksensoren bekannt. Hierbei wird jeweils eine Fügefläche eines Gegenkörperwafers und eines Entkopplungskörperwafers derart aufeinander gefügt, dass in ihnen enthaltene Druckkanäle aufeinander zu liegen kommen. Zur Verbindung des Gegenkörperwafers des Entkopplungskörperwafers wird ein Fusionbonden eingesetzt. Nach Abschluss des Verbindens von Gegenkörperwafer und Entkopplungswafer wird mittels eines Si-Au-Eutektikums ein Membranwafer auf die freie Oberfläche des Gegenkörperwafers aufgebracht.

### VORTEILE DER ERFINDUNG

Das erfindungsgemäße Herstellungsverfahren für ein mikromechanisches Bauelement mit den Merkmalen des Anspruchs 1 weist den Vorteil auf, dass die betreffenden mikromechanischen Bauelemente unter der ausschließlichen Verwendung von Waferprozessen oder von einer Kombination aus Wafer- und Batchprozessen einfach, sicher und insbesondere lunkerfrei, hergestellt werden können. Die Minimierung der Lunkerbildung beim Löten ermöglichen Ausgasungskanäle in den gedruckten Sealglas-Strukturen und eventuell eine konvexe Form der Chips beim Auflöten.

Dadurch erhöht sich die elektrische Bauteilstabilität. Durch den Einsatz von Verbundsubstraten anstelle von Einzelsubstraten lässt sich eine Vereinfachung und Rationalisierung der Herstellung erreichen.

Durch Vereinzelungsverfahren für nicht-lineare Konturen im Verbund können die Außenkontur vom Chip und vereinzeltem Substrat aufeinander abgestimmt werden. Dies ermöglicht eine hohe Flächennutzung im Halbleiterwafer bei gleichzeitiger günstiger Montagegeometrie am vereinzelten Substrat (z. B. rund, vieleckig oder rechteckig). Zudem weist das erfindungsgemäße Verfahren eine exzellente Shrink-Fähigkeit auf.

Die der vorliegenden Erfindung zu Grunde liegende Idee besteht im Aufbringen einer strukturierten Haftvermittlungsschicht, beispielsweise durch ein Aufdrucken, auf die erste vorderseitige Oberfläche und/oder die zweite vorderseitige Oberfläche welche Ausgasungskanäle aufweist, wodurch im Verbund jeder Halbleiterchip mit einem entsprechenden Trägersubstrat entsprechend einem jeweiligen mikromechanischen Bauelement im Wesentlichen lunkerfrei verbunden wird, indem ein Gas der Umgebungsatmosphäre durch die Ausgasungskanäle beim Verbindungsprozessschritt nach außerhalb entweichen kann.

In den Unteransprüchen finden sich vorteilhafte Weiterbildungen und Verbesserungen des jeweiligen Gegenstandes der Erfindung.

Gemäß einer weiteren bevorzugten Weiterbildung ist der Siliziumwafer derart gestaltet, dass die Halbleiterchips über einen oder mehrere Stützbereiche, die von einem jeweiligen Hohlraum umgeben sind, mit einem Waferhauptkörper verbunden sind. Beispielsweise durch den Einsatz von porösem Silizium lassen sich derartige defektarme dünne Siliziumchips herstellen, ohne dass es der Verfahrensschritte Rückschleifen, Polieren oder Plasmaätzen bedarf. Der Einsatz des Ursprungswafers als Träger von derartigen dünnen Siliziumchips anstelle von Rückdünn-, Auflaminier- und mehrfachen Transferlaminierprozessen ermöglicht eine deutlich vereinfachte Handhabung.

Gemäß einer weiteren bevorzugten Weiterbildung umfasst der Schritt des Verbindens einen thermischen und/oder mechanischen Schritt, wobei die Stützbereiche brechen und dadurch der Waferhauptkörper von den Halbleiterchips gelöst wird.

Gemäß einer weiteren bevorzugten Weiterbildung ist der Siliziumwafer derart gestaltet, dass die Vielzahl von Halbleiterchips auf einer Sägefolie vorgesehen ist.

Eine Vereinfachung der Handhabung und der Justage der Substrate wird durch Einsatz von solchen Großsubstraten anstelle von Einzelsubstraten und Werkstückträgersystemen erreicht.

Gemäß einer weiteren bevorzugten Weiterbildung ist der Edelstahlwafer derart gestaltet ist, dass die Vielzahl von Trägersubstraten mittels einer Trägereinrichtung verbunden ist.

Gemäß einer weiteren bevorzugten Weiterbildung ist die Haftvermittlungsschicht eine Sealglasschicht, die zum Verbinden auf eine Temperatur im Bereich 100 bis 500 °C erwärmt wird. Der Einsatz des Wafer-Sealglas-Bonden anstelle vom Einzelchip-Bonden mit einem "Pick and Place-Werkzeug" ermöglicht eine Vereinfachung und Rationalisierung des Lötens. Chipdefekte beim Sealglas-Bonden lassen sich durch Einleiten der Anpresskraft über die Chiprückseite anstelle mit einem Pick and-Place-Werkzeug auf die Chipvorderseite vermeiden.

Gemäß einer weiteren bevorzugten Weiterbildung weist die Haftvermittlungsschicht (SG) ein Druckmuster mit einer Vielzahl von separaten Strukturen (SGS) mit ersten Ausgasungskanälen (SK) auf, wobei die separaten Strukturen (SGS) durch zweite Ausgasungskanäle (KG) getrennt sind.

Gemäß einer weiteren bevorzugten Weiterbildung sind die Trägersubstrate Stahlsubstrate.

Gemäß einer weiteren bevorzugten Weiterbildung weist auf der ersten vorderseitigen Oberfläche jeder Halbleiterchip eine integrierte Schaltung auf, wobei die erste vorderseitige Oberfläche mit der zweiten vorderseitigen Oberfläche über die strukturierte Haftvermittlungsschicht verbunden wird.

Gemäß einer weiteren bevorzugten Weiterbildung wird nach dem Verbinden vor dem Vereinzeln ein Schritt des Durchkontaktierens der Halbleiterchips ausgehend von der ersten rückseitigen Oberfläche durchgeführt wird.

Gemäß einer weiteren bevorzugten Weiterbildung wird vor dem Durchkontaktieren ein Schritt des Abdünnens des Siliziumwafer der Vielzahl von Halbleiterchips an der ersten rückseitigen Oberfläche durchgeführt.

### ZEICHNUNGEN

Ausführungsbeispiele der Erfindung sind in den Zeichnungen dargestellt und werden in der nachfolgenden Beschreibung näher erläutert.

Es zeigen:
- Fig. 1a,b bis Fig. 4a,b: schematische Querschnittsansichten zur Erläuterung eines Herstellungsverfahrens für ein mikromechanisches Bauelement gemäß einer ersten Ausführungsform der vorliegenden Erfindung;
- Fig. 5: eine schematische Querschnittsansicht zur Erläuterung eines Einbaukonzepts für ein mikromechanisches Bauelement gemäß der ersten Ausführungsform der vorliegenden Erfindung;
- Fig. 6: eine schematische Querschnittsansicht zur Erläuterung eines Herstellungsverfahrens für ein mikromechanisches Bauelement gemäß einer zweiten Ausführungsform der vorliegenden Erfindung;
- Fig. 7: eine schematische Querschnittsansicht zur Erläuterung eines Herstellungsverfahrens für ein mikromechanisches Bauelement gemäß einer dritten Ausführungsform der vorliegenden Erfindung;
- Fig. 8a,b: schematische Querschnittsansichten zur Erläuterung eines Herstellungsverfahrens für ein mikromechanisches Bauelement gemäß einer vierten Ausführungsform der vorliegenden Erfindung; und
- Fig. 9a,b: schematische Querschnittsansichten zur Erläuterung eines Herstellungsverfahrens für ein mikromechanisches Bauelement gemäß einer fünften Ausführungsform der vorliegenden Erfindung.

### BESCHREIBUNG DER AUSFÜHRUNGSBEISPIELE

In den Figuren bezeichnen gleiche Bezugszeichen gleiche oder funktionsgleiche Komponenten.

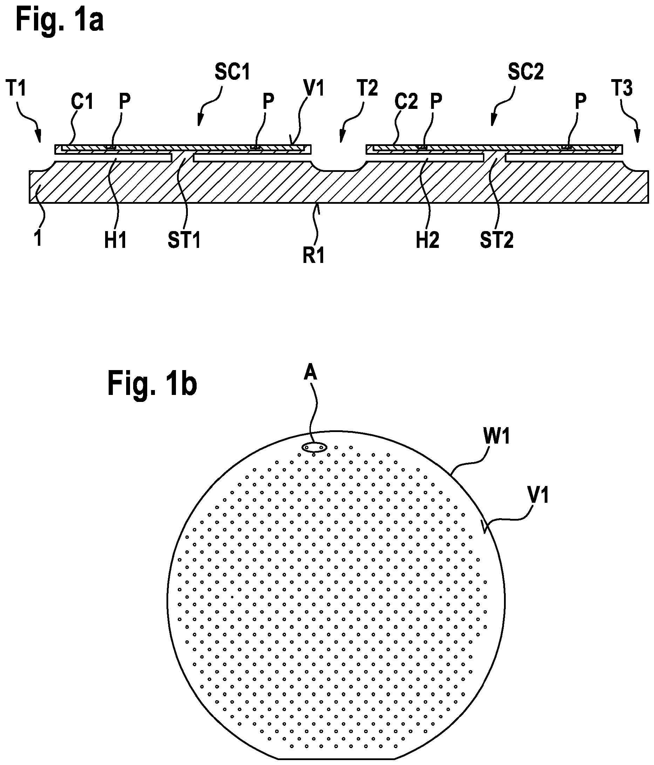

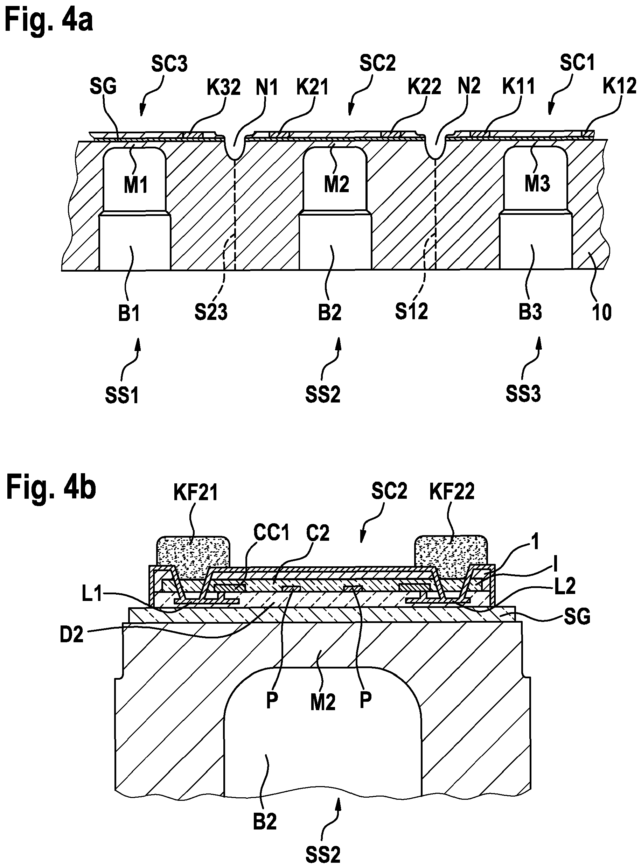

Fig. 1a,b bis Fig. 4a,b sind schematische Querschnittsansichten zur Erläuterung eines Herstellungsverfahrens für ein mikromechanisches Bauelement gemäß einer ersten Ausfuhrungsform der vorliegenden Erfindung.

In Fig. 1a,b bezeichnet Bezugszeichen 1 einen Silizium-Waferhauptkörper eines Siliziumwafers W1, mit dem dünne Silizium-Sensorchips SC1, SC2, ... über einen jeweiligen Steg bzw. Stützbereich ST1, ST2, ... verbunden sind.

Ersichtlich aus Fig. 1b ist, dass Fig. 1a den Ausschnitt A des Wafers W1 gemäß Fig. 1b wiedergibt. Die Silizium-Sensorchips SC1, SC2, ... weisen an ihrer Vorderseite eine integrierte Schaltung C1 bzw. C2 auf, in der eine piezosensitive Einrichtung P vorgesehen ist, welche zur Druckerfassung verwendet wird. Die Stützstellen ST1, ST2, ... bestehen aus Silizium und werden beispielsweise entsprechend dem in der DE 10 2005 035 057 A1 beschriebenen Verfahren hergestellt. Die Stützstellen ST1, ST2, ... sind von einem jeweiligen Hohlraum H1 bzw. H2 usw. umgeben.

Die oberhalb des jeweiligen Hohlraums H1, H2 liegenden Silizium-Sensorchips SC1, SC2 sind besonders dünn ausgeführt, um sie für Hochdrucksensorelemente geeignet zu gestalten. Die Stützstellen ST1, ST2, ... aus Silizium fixieren die Silizium-Sensorchips SC1, SC2, ... während der im Verbund durchzuführenden Halbleiter- und Mikromechanik-Prozesse. Eine bevorzugte Anordnung der Stützstellen ST1, ST2, ... ist im mittleren Bereich der Silizium-Sensorchips SC1, SC2, .... Es können auch mehrere Stützstellen pro Chip vorgesehen werden.

Durch eine derartige Anordnung können die Silizium-Sensorchips SC1, SC2, ... beim Vorderseiten-Trockenätzen zum Herstellen von Trenngräben T1, T2, T3 durch Eigenspannungen eine leicht konvexe Form annehmen, d. h. die seitlichen Enden der Silizium-Sensorchips SC1, SC2, ... liegen näher am Waferhauptkörper 1 als der mittlere Bereich. Die konvexe Form vermeidet somit Gaseinschlüsse und Lunker bei einem später durchzuführenden Sealglas-Bondprozess, welcher weiter unten beschrieben wird. Die zwischen den Silizium-Sensorchips SC1, SC2, ... vorgesehenen Trenngräben T1, T2, T3 erstrecken sich bis in den Waferhauptkörper 1. Sie sollten mit einer vorbestimmten Mindestbreite und - tiefe ausgeführt werden, welche die Wärmedehnung und die Meniskusbildung bei dem später durchzuführenden Sealglas-Waferbonden ermöglicht.

Die Anordnung gemäß Fig. 1a,b ist somit ein erster Verbund einer Vielzahl von Halbleiterchips SC1, SC2, ..., wobei der erste Verbund eine erste vorderseitige Oberfläche V1 und eine erste rückseitige Oberfläche R1 aufweist. Die erste vorderseitige Oberfläche V1 wird gebildet durch die Gesamtheit der vorderseitigen Oberflächen der Silizium-Sensorchips SC1, SC2, ..., wie in Fig. 1b dargestellt.

Die Trenngräben T1, T2, T3, welche durch das Vorderseiten-Trockenätzverfahren hergestellt werden, können in beliebiger Form hergestellt werden. Damit kann die Form der Silizium-Sensorchips SC1, SC2, ... der gewünschten Form der damit zu verbindenden Trägersubstrate angepasst werden, welche hier beispielsweise aus Stahl bestehen.

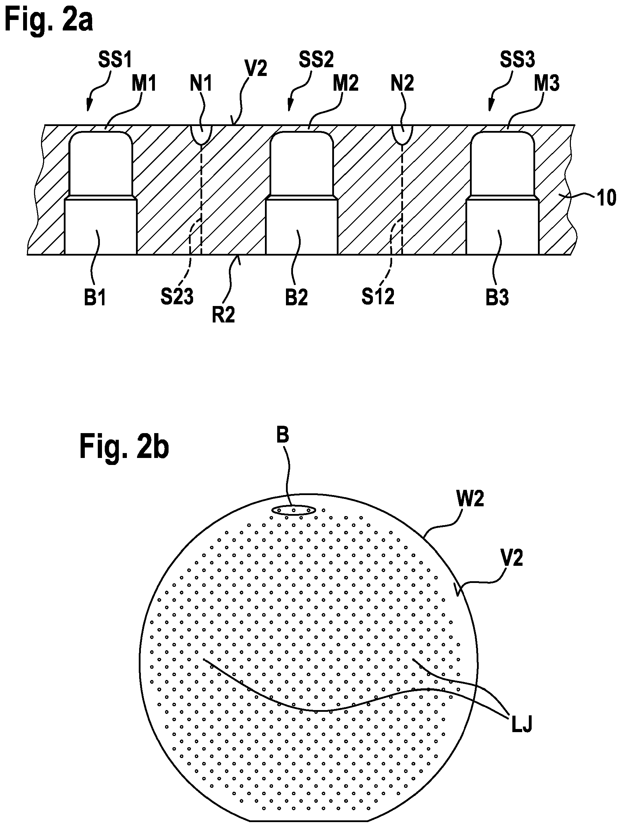

In Fig. 2a,b bezeichnet Bezugszeichen 10 einen Trägersubstrat-Hauptkörper aus Stahl, welcher in Form eines Wafers W2 vorliegt, wobei der Wafer W2 bevorzugt die gleichen Abmessungen wie der im Zusammenhang mit Fig. 1a,b beschriebene Wafer W1 hat. Der Wafer W2 weist eine zweite vorderseitige Oberfläche V2 und eine zweite rückseitige Oberfläche R2 auf.

In Fig. 2a ist der Ausschnitt B von Fig. 2b dargestellt. Durch rückseitige Bohrungen B1, B2, B3, ... sind an der zweiten vorderseitigen Oberfläche V2 eine Mehrzahl von Hochdruckmembranen M1, M2, M3, ... vorgesehen. Das Raster der Hochdruckmembranen M1, M2, M3, ... entspricht dem Raster der Siliziumchips SC1, SC2, ... auf dem Siliziumwafer W1.

Zur Justage des Edelstahlwafers W2 während des später durchzuführenden Sealglas-Bondens zur Verbindung mit dem Siliziumwafer W1 besitzt der Edelstahl-Wafer W2 zwei optisch auswertbare Justagelöcher LJ, welche im Raster der Hochdruckmembranen M1, M2, M3 ... untergebracht sind und zusammen mit diesen hergestellt werden. Durch diese gemeinsame mechanische Herstellung beispielsweise in einer Aufspanneinrichtung wird eine sehr gute Lagegenauigkeit der Justagelöcher LJ zu den Membranen M1, M2, M3, ... bzw. Membranbohrungen B1, B2, B3, ... sichergestellt.

An der zweiten vorderseitigen Oberfläche V2 weiterhin vorgesehen sind Nuten N1, N2, welche eine Vereinfachung beim späteren Vereinzeln der individuellen Trägersubstrate aus Stahl SS1, SS2, SS3, ... durch Sägen entlang der Sägelinien S12, S23, ... bzw. beim späteren Montieren durch Laserschweißen schaffen.

Somit enthält der Edelstahlwafer W2 einen zweiten Verbund einer Vielzahl von Trägersubstraten SS1, SS2, SS3, ..., wobei der zweite Verbund die zweite vorderseitige Oberfläche V2 und die zweite rückseitige Oberfläche R2 aufweist, wobei die zweite vorderseitige Oberfläche V2 in einem späteren Verfahrensabschnitt mit den Silizium-Sensorchips SC1, SC2, ... im Verbund des Wafers W1 zu verbinden ist.

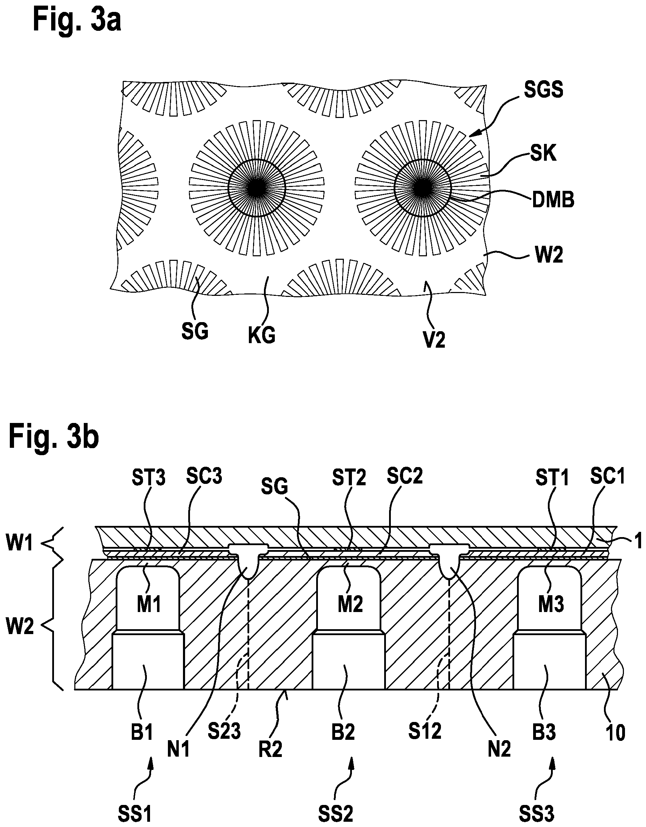

In Fig. 3a,b dargestellt sind der Schritt des Aufdruckens einer strukturierten Sealglas-Schicht SG auf die zweite vorderseitige Oberfläche V2 des Edelstahlwafers W2 (Fig. 3a) und der Schritt des Verbindens der Wafer W1 und W2 über die Sealglas-Schicht SG.

Das Bedrucken gemäß Fig. 3a erfolgt beispielsweise durch Siebdruck oder Dispensen. Dabei werden einzelne, voneinander durch breite Ausgasungskanäle KG getrennte Sealglas-Strukturen SGS derartig ausgeführt, dass an jeder Position einer Edelstahlmembran M1, M2, M3, ... eine Sealglas-Struktur mit schmalen Ausgasungskanälen SK zum lunkerarmen Sealglas-Bonden der Siliziumchips SC1, SC2, ... vorliegt. Die schmalen Ausgasungskanäle SK münden in die breiten Ausgasungskanäle KG. Die breiten Ausgasungskanäle KG ermöglichen den vollständigen Abtransport der Gase nach außen über den Waferrand der aufeinanderliegenden Wafer W1, W2, da sie bis dorthin führen. Beispiele für Ausführungsmöglichkeiten der Ausgasungskanäle SK sind eine kuchensegmentförmige Struktur, eine streifenförmige Struktur, eine gitterförmige Struktur, u. ä.

Bezugszeichen DMB in Fig. 3a bezeichnet den Durchmesser der Stahlmembranen M1, M2, M3, .... Daraus ist ersichtlich, dass die Sealglas-Strukturen SGS einen größeren Durchmesser als die Stahlmembranen M1, M2, M3, .... aufweisen, da auch die Silizium-Sensorchips SC1, SC2, SC3, ... einen größeren Durchmesser als die Stahlmembranen M1, M2, M3, .... aufweisen. Der Durchmesser der Sealglas-Strukturen SGS entspricht im Wesentlichen dem Durchmesser der Silizium-Sensorchips SC1, SC2, SC3.

Zusätzlich oder alternativ kann der Siliziumwafer W1 mit derartigen Sealglas-Strukturen SGS bedruckt werden.

Zur optischen Ausrichtung der Sealglas-Strukturen SGS werden die Justagelöcher LJ des EdelstahlWafers W2 verwendet. Nach dem Ausrichten der Wafer W1, W2 entsprechend der Vielzahl von zu bildenden mikromechanischen Bauelementen, welche jeweils einen Silizium-Sensorchip und ein entsprechendes Trägersubstrat aus Stahl aufweisen, erfolgt ein Verbinden der ersten vorderseitigen Oberfläche V1 der zweiten vorderseitigen Oberfläche V2 über die strukturierte Sealglas-Schicht SG, um einen entsprechenden Verbund mikromechanischer Bauelemente zu bilden, wie in Fig. 3b dargestellt.

Das Verbinden erfolgt durch die bekannte Technik des Sealglas-Waferbonden bei Temperaturen zwischen 100°C und 500°C und entsprechend gewählter Anpresskraft, beispielsweise unter Verwendung eines entsprechenden Stempels, wodurch Hohlräume zwischen den Membranen M1, M2, M3, ... und den Sensorchips SC1, SC2, SC3, ... vermieden werden können. Durch die mechanische Anpresskraft beim Sealglas-Waferbonden, durch einen thermomechanischen Spaltvorgang beim Abkühlen während des Sealglas-Waferbondens mit unterschiedlichen thermischen Ausdehnungskoeffizienten des Siliziumwafers W1 und des Edelstahlwafers W2, durch mechanische Krafteinwirkung oder durch einen chemischen Angriff auf die Stützstellen ST1, ST2, ST3, ... werden die Stützstellen ST1, ST2, ST3, ... gezielt getrennt und damit die feste Verbindung des Waferhauptkörpers 1 mit den Silizium-Sensorchips SC1, SC2, SC3, ... gelöst. Diese Trennung ermöglicht Verschiebungen und damit ein eigenspannungsarmes Abkühlen des Edelstahlwafers W2 und der aufgelöteten Silizium-Sensorchips SC1, SC2, SC3, ... . Nach Abkühlen wird der Waferhauptkörper 1 einfach von der gebildeten Struktur abgehoben.

Fig. 4a zeigt den Zustand nach Abheben des Waferhauptkörpers 1 und einer optionalen Glättung der Rückseiten der Silizium-Sensorchips SC1, SC2, SC3, ....

In einem anschließenden, ebenfalls in Fig. 4a dargestellten Prozessschritt erfolgt eine Rückseiten-Durchkontaktierung der Silizium-Sensorchips SC1, SC2, SC3, wobei ausgehend von der Rückseite Kontaktlöcher K11, K12, K21, K22, K32 ... gebildet werden, um eine in der Vorderseite der Halbleiterchips SC1, SC2, SC3 vorgesehene Leiterbahneinrichtung L1, L2 der jeweiligen integrierten Schaltung von der Rückseite der Halbleiterchips SC1, SC2, SC3, ... her anzuschließen.

Fig. 4b ist eine vergrößerte Detailansicht zur Erläuterung der Rückseiten-Durchkontaktierung des Silizium-Sensorchips SC2.

Zur Kontaktierung der Leiterbahnen L1, L2, welche in einer vorderseitigen Dünnschichtkeramik D2 (für die erste Ausführungsform nur in Fig. 4b gezeigt) der Schaltung C2 vorgesehen sind, wird die Rückseite des Silizium-Sensorchips SC2 mit einer entsprechenden (nicht dargestellten) Lackmaske versehen, wonach ein entsprechender Trockenätzvorgang der Kontaktlöcher K21, K22 bis auf die Leiterbahnen L1, L2 z.B. mit entsprechendem Ätzstopp erfolgt.

Die Erstellung der Lackmaske ist durch die Topographie des Edelstahlwafers W2 mit den aufgelöteten Silizium-Sensorchips SC1, SC2, SC3, ... erschwert. Darum wird vorzugsweise eine Sprühbelackung angewendet, und dabei werden große Kontakte z. B. für eine Leitkleberkontaktierung mit geringeren Anforderungen an die Strukturgenauigkeit hergestellt. Nach dem Trockenätzschritt wird noch eine Isolierschicht I auf der Rückseite der Silizium-Sensorchips SC1, SC2, SC3 abgeschieden und durch erneute Lithographie und nachfolgendes Trockenätzen mit Ätzstopp in den Leiterbahnen L1, L2 die Kontaktlöcher K21, K22 zu den Leiterbahnen L1, L2 geöffnet.

Im Anschluss daran werden Leitkleberkontaktfüllungen KF21, KF22 in die Kontaktlöcher K21, K22 gefüllt, was zum Prozesszustand gemäß Fig. 4b führt.

Es sollte noch bemerkt werden, dass die Leiterbahnen L1, L2 mit Schaltungsanschlussbereichen CC1 bzw. CC2 der integrierten Schaltung C2 verbunden sind, welche wiederum über weitere nicht gezeigte Leiterbahnen und andere elektronische Komponenten mit der piezoelektrischen Einrichtung P verbunden sind.

Im Anschluss an den Prozesszustand gemäß Fig. 4a,b erfolgt eine Vereinzelung des Bauelementeverbundes in die Bauelemente, welche jeweils aus einem Silizium-Sensorchip und einem Trägersubstrat aus Stahl bestehen. Dazu erfolgt ein Sägeprozess entlang der jeweiligen Sägelinien S12, S23, .... Zum Sägen kann beispielsweise ein Laser-Wasserstrahl-Schneiden verwendet werden, wobei eine für das Aufschweißen der Sensorbauelemente auf einen Anschlussstutzen geeignete Außenkontur, beispielsweise rund, erzeugt wird. Die Handhabung der vereinzelten Bauelemente während und nach der Vereinzelung erfolgt auf einem (nicht gezeigten) Glasfaser-Tape oder sonstigen geeigneten Träger.

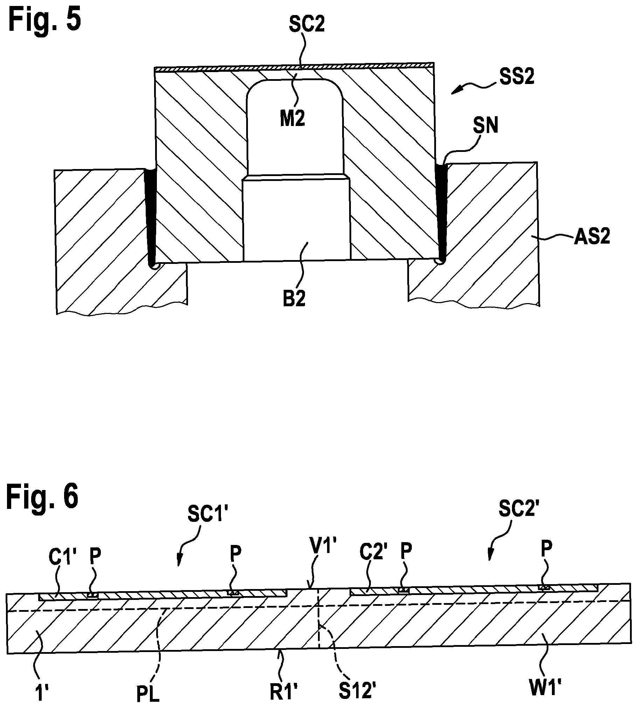

Fig. 5 ist eine schematische Querschnittsansicht zur Erläuterung eines Einbaukonzepts für ein mikromechanisches Bauelement gemäß der ersten Ausführungsform der vorliegenden Erfindung.

Wie in Fig. 5 dargestellt, erfolgt zur Montage ein Aufschweißen des Sensorbauelements bestehend aus dem Trägersubstrat SS2 und dem Silizium-Sensorchips SC2 auf einen Anschlussstutzen AS2 durch Strahlschweißen am Umfang, wobei die Schweißnaht SN gebildet wird. Durch das besagte Umfangsschweißen wird die Schweißnaht SN im Anwendungsbetrieb bevorzugt durch Druckspannungen belastet, was eine Dauerfestigkeitsauslegung des betreffenden Sensors für besonders hohe Drücke ermöglicht. Durch das Schweißen nur im unteren Bereich des Sensorbauelements kann der Abstand der thermischen Schweißeinflusszone zum Silizium-Sensorchip SC2 verhältnismäßig groß gehalten werden.

Im Anschluss an den in Zusammenhang mit Fig. 5 erläuterten Prozesszustand erfolgt ein Abgleich der Sensorbauelemente über Druck und Temperatur. Der Abgleich eines Sensorbauelements ohne Auswerteelektronik erfolgt im zugehörigen ASIC (Zweichiplösung), bei Sensorelementen mit integrierter Auswerteelektronik ist ein Abgleich mittels Thyristor-Zapping oder Zehner-Zapping möglich.

Als beispielhafte Einsatzgebiete für die derartig aufgebauten Hochdrucksensoren seien Kraftstoffeinspritzanlagen, Klimaanlagen oder Getriebeanlagen erwähnt.

Fig. 6 ist eine schematische Querschnittsansicht zur Erläuterung eines Herstellungsverfahrens für ein mikromechanisches Bauelement gemäß einer zweiten Ausführungsform der vorliegenden Erfindung.

Bei der in Fig. 6 dargestellten zweiten Ausführungsform unterscheidet sich der erste Verbund der Vielzahl von Halbleiterchips SC1', SC2', ... insofern, als dass jeder Halbleiterchip SC1', SC2', ... vollständig in den Waferhauptkörper 1' von einem Wafer W1' integriert ist, also keine Stützstellen aus Silizium wie bei der ersten Ausführungsform vorhanden sind.

Der Wafer W1' weist eine erste vorderseitige Oberfläche V1' und eine erste rückseitige Oberfläche R1' auf. Der Aufbau der Schaltungen C1', C2' in den Sensorchips SC1', SC2' entspricht dem Aufbau der Schaltungsbereiche C1, C2 einschließlich der piezoelektrischen Einrichtung P, welche im Zusammenhang mit Fig. 1a,b erläutert worden sind.

Zusätzlich bezeichnet in Fig. 6 Bezugszeichen PL eine Polierlinie, bis zu der hin nach dem Sealglas-Waferbonden der Oberfläche V1' auf die Oberfläche V2 des Edelstahlwafers W2 ein Abdünnen des Wafers W1' von der zweiten rückseitigen Oberfläche R1' her erfolgt, um die geforderte geringe Dicke der Silizium-Sensorchips SC1', SC2', ... zu erreichen. Es sollte erwähnt werden, dass das Rückdünnen des Wafers W1' von der zweiten rückseitigen Oberfläche R1' her beispielsweise durch Ätzen oder chemisch-mechanischen Abtrag erfolgen kann. Schließlich bezeichnet Bezugszeichen S12' eine Linie für einen Vereinzelungsprozess, beispielsweise durch Sägen. Bei diesem Vereinzelungsprozess wird im Gegensatz zur ersten Ausführungs form auch der Waferhauptkörper 1' des Wafers W1' gleichzeitig mit dem Edelstahl-Wafer W2 durchtrennt.

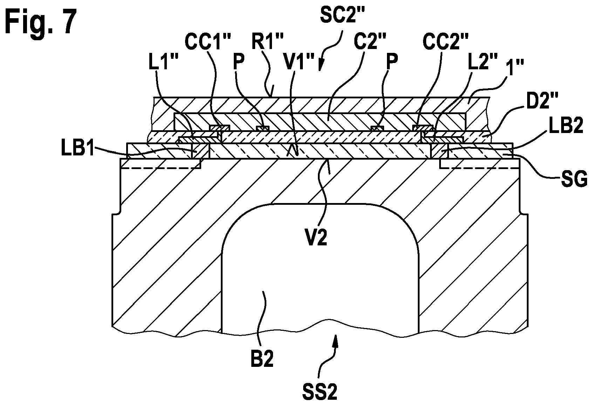

Fig. 7 ist eine schematische Querschnittsansicht zur Erläuterung eines Herstellungsverfahrens für ein mikromechanisches Bauelement gemäß einer dritten Ausführungsform der vorliegenden Erfindung.

Bei der dritten Ausführungsform gemäß Fig. 7 erfolgt im Gegensatz zur oben beschriebenen ersten Ausführungsform keine Rückseiten-Durchkontaktierung des dortigen Silizium-Sensorchips SC2" von seiner rückseitige Oberfläche R1", sondern ein simultanes Sealglas-Waferbonden der vorderseitigen Oberfläche V1" und ein gleichzeitiges Auflöten von Lothügeln LB1, LB2, die auf schaltungsseitigen Leiterbahnen L1", L2" in der Dünnschichtkeramik D2" vorgesehen sind, auf entsprechende Leiterbahnen, welche isoliert in oder auf der Oberfläche V2 des Trägersubstrats SS2 vorgesehen sind (gestrichelt angedeutet). Die Leiterbahnen L1" und L2" sind wie bei der ersten Ausführungsform mit entsprechenden Schaltungsanschlussbereichen CC1", CC2" der integrierten Schaltung C2" verbunden.

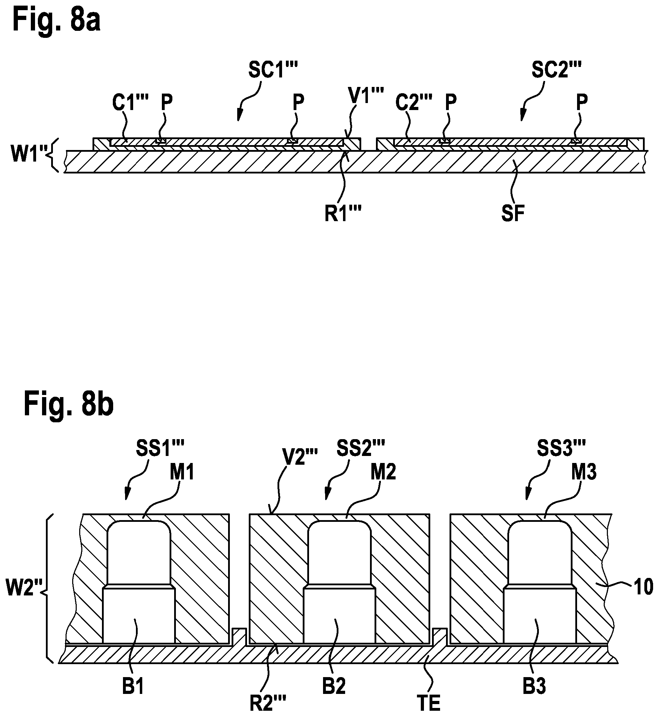

Fig. 8a,b sind schematische Querschnittsansichten zur Erläuterung eines Herstellungsverfahrens für ein mikromechanisches Bauelement gemäß einer vierten Ausführungsform der vorliegenden Erfindung.

Bei der vierten Ausführungsform gemäß Fig. 8 ist der erste Verbund der Vielzahl von Halbleiterchips SC1"', SC2"', ... auf einer eingerahmten Sägefolie SF in einem Verbund W1" vorgesehen, wobei die Silizium-Sensorchips SC1"', SC2"', ... Schaltungsbereiche CC1"', CC2"', ... aufweisen, welche den bereits erläuterten Schaltungsbereichen C1, C2 einschließlich der piezosensitiven Einrichtung P entsprechen. Ausgehend vom Prozesszustand gemäß Fig. 6 sind also die Halbleiterchips SC1"', SC2"', ... bereits gedünnt und in Einzelchips SC1"', SC2"', ... zersägt. Für den Zusammenhalt dieses Verbundes W1" sorgt lediglich die eingerahmte Sägefolie SF. V1"' bezeichnet die erste vorderseitige Oberfläche des ersten Verbundes W1", wohingegen R1"' die erste rückseitige Oberfläche des ersten Verbundes W1" bezeichnet.

Unterschiedlich zu den vorher beschriebenen Ausführungsformen ist bei der vierten Ausführungsform ebenfalls, dass die Trägersubstrate aus Stahl SS1"', SS2"', SS3"', ... nicht in Form eines Edelstahlwafers vorliegen, sondern als Einzelsubstrate, welche mittels einer Trägereinrichtung TE als Verbund W2' verbunden sind, wie beispielsweise in der DE 199 34 114 A1 ausführlich erläutert. V2"' bezeichnet die zweite vorderseitige Oberfläche des Verbundes W2", während R2"' seine zweite rückseitige Oberfläche bezeichnet.

Im Anschluss an den Prozesszustand gemäß Fig. 8 erfolgen das bereits im Zusammenhang mit der ersten Ausführungsform beschriebene Sealglas-Bonden, Rückseiten-Kontaktieren, Vereinzeln sowie die weiteren, daran anschließenden Prozessschritte.

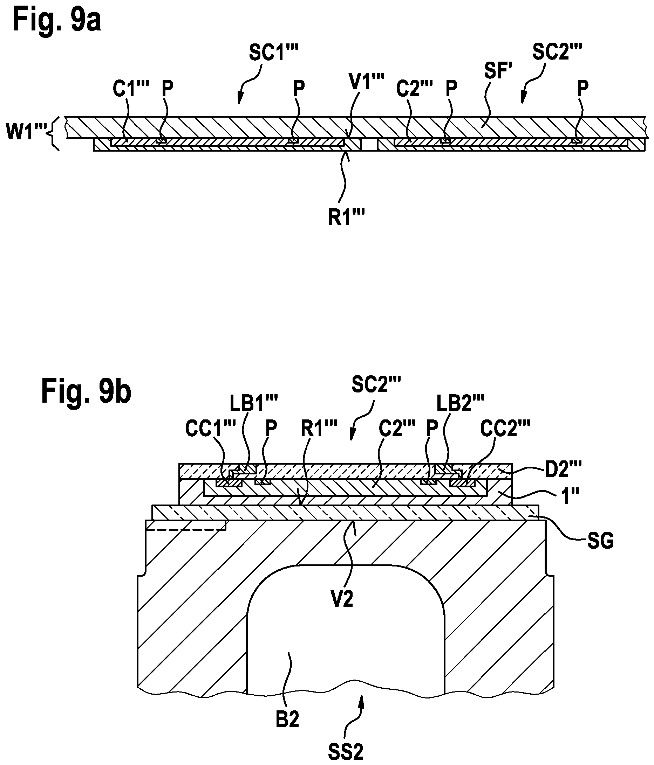

Fig. 9a,b sind schematische Querschnittsansichten zur Erläuterung eines Herstellungsverfahrens für ein mikromechanisches Bauelement gemäß einer fünften Ausführungsform der vorliegenden Erfindung. Bei der fünften Ausführungsform gemäß Fig. 9a,b sind die abgedünnten und vereinzelten Sensorchips SC1"', SC2"', ... über eine eingerahmte Sägefolie SF' in einem Verbund W1"' verbunden, die im Unterschied zur vierten Ausführungsform an der ersten vorderseitigen Oberfläche V1"' angebracht ist, wohingegen deren erste rückseitige Oberfläche R1"' freiliegt.

Dementsprechend erfolgt ein Verlöten der ersten rückseitigen Oberfläche R1"' mit der zweiten vorderseitigen Oberfläche V2 des Stahlträgersubstrats SS2 mit dem Chip SC2"' usw., dessen Schaltungsanschlussbereiche CC1"', CC2"' der Schaltung C2"' über durch die Dünnschichtkeramik D2"' verlaufende Leiterbahnen LB1"', LB2"' mit der vorderseitigen Oberfläche V1"' verbunden sind. Die Leiterbahnen LB1"', LB2"' können dann später mittels Bonden oder anderer Techniken elektrisch angeschlossen werden.

## Patentansprüche

1. Herstellungsverfahren für ein mikromechanisches Bauelement mit den Schritten:
Bereitstellen eines Siliziumwafers (W1; W1'; W1"; W1"') mit einer Vielzahl von Halbleiterchips (SC1, SC2, SC3; SC2"; SC1"', SC2"'; SC3"'), wobei der Siliziumwafer eine erste vorderseitige Oberfläche (V1; V1'; V1"; V1"') und eine erste rückseitige Oberfläche (R1; R1'; R1"; R1"') aufweist;
Bereitstellen eines Edelstahlwafers (W2; W2') mit einer entsprechenden Vielzahl von Trägersubstraten (SS1, SS2, SS3; SS1"', SS2"', SS3"'), wobei der Edelstahlwafer eine zweite vorderseitige Oberfläche (V2; V2"') und eine zweite rückseitige Oberfläche (R2; R2"') aufweist;
Aufbringen einer strukturierten Haftvermittlungsschicht (SG) auf die erste vorderseitige Oberfläche (V1; V1'; V1"; V1"') und/oder die zweite vorderseitige Oberfläche (V2; V2"'), welche Ausgasungskanäle (SK, KG) aufweist;
Ausrichten der ersten vorderseitigen Oberfläche (V1; V1'; V1"; V1"') und der zweiten vorderseitige Oberfläche (V2; V2"') entsprechend einer Vielzahl von mikromechanischen Bauelementen, welche jeweils einen Halbleiterchip (SC1, SC2, SC3; SC2"; SC1"', SC2"'; SC3"') und ein entsprechendes Trägersubstrat (SS1, SS2, SS3; SS1"', SS2"', SS3"') aufweisen;
Verbinden der ersten vorderseitigen Oberfläche (V1; V1'; V1"; V1"') und der zweiten vorderseitigen Oberfläche (V2; V2"') über die strukturierte Haftvermittlungsschicht (SG) unter Anlegen von Druck derart, dass jeder Halbleiterchip (SC1, SC2, SC3; SC2"; SC1"', SC2"'; SC3"') mit einem entsprechenden Trägersubstrat (SS1, SS2, SS3; SS1"', SS2"', SS3"') entsprechend einem jeweiligen mikromechanischen Bauelement verbunden wird, wobei ein Gas der Umgebungsatmosphäre durch die Ausgasungskanäle (SK, KG) nach außerhalb entweichen kann;
Vereinzeln der mikromechanischen Bauelemente.

2. Herstellungsverfahren nach Anspruch 1, wobei der Siliziumwafer (W1) derart gestaltet ist, dass die Halbleiterchips (SC1, SC2, SC3) über einen oder mehrere Stützbereiche (ST1, ST2), die von einem jeweiligen Hohlraum (H1, H2) umgeben sind, mit einem Waferhauptkörper (1) verbunden sind.

3. Herstellungsverfahren nach Anspruch 2, wobei der Schritt des Verbindens einen thermischen Schritt umfasst, wobei die Stützbereiche (ST1, ST2) brechen und dadurch der Waferhauptkörper (1) von den Halbleiterchips (SC1, SC2, SC3) gelöst wird.

4. Herstellungsverfahren nach Anspruch 1, wobei der Siliziumwafer (W1; W1'; W1"; W1"') derart gestaltet ist, dass die Vielzahl von Halbleiterchips (SC1, SC2, SC3; SC2"; SC1"', SC2"'; SC3"') auf einer Sägefolie (SF; SF') vorgesehen ist.

5. Herstellungsverfahren nach Anspruch 1, wobei der Edelstahlwafer (W2; W2') derart gestaltet ist, dass die Vielzahl von Trägersubstraten (SS1, SS2, SS3; SS1"', SS2"', SS3"') mittels einer Trägereinrichtung (TE) verbunden ist.

6. Herstellungsverfahren nach einem der vorhergehenden Ansprüche, wobei die Haftvermittlungsschicht (SG) eine Sealglasschicht ist, die zum Verbinden auf eine Temperatur im Bereich 100 bis 500 °C erwärmt wird.

7. Herstellungsverfahren nach einem der vorhergehenden Ansprüche, wobei die Haftvermittlungsschicht (SG) ein Druckmuster mit einer Vielzahl von separaten Strukturen (SGS) mit ersten Ausgasungskanälen (SK) aufweist, und wobei die separaten Strukturen (SGS) durch zweite Ausgasungskanäle (KG) getrennt sind.

8. Herstellungsverfahren nach einem der vorhergehenden Ansprüche, wobei die Trägersubstrate (SS1, SS2, SS3; SS1"', SS2"', SS3"') Stahlsubstrate sind.

9. Herstellungsverfahren nach einem der vorhergehenden Ansprüche, wobei auf der ersten vorderseitigen Oberfläche (V1; V1'; V1"; V1"') jeder Halbleiterchip (SC1, SC2, SC3; SC2"; SC1"', SC2"'; SC3"') eine integrierte Schaltung (C1, C2; C1', C2'; C2"; C1"', C2"') aufweist und die erste vorderseitige Oberfläche (V1; V1'; V1"; V1"') mit der zweiten vorderseitigen Oberfläche (V2; V2"') über die strukturierte Haftvermittlungsschicht (SG) verbunden wird.

10. Herstellungsverfahren nach Anspruch 9, wobei nach dem Verbinden vor dem Vereinzeln ein Schritt des Durchkontaktierens der Halbleiterchips (SC1, SC2, SC3; SC2"; SC1"', SC2"'; SC3"') ausgehend von der ersten rückseitigen Oberfläche (R1; R1'; R1"; R1"') durchgeführt wird.

11. Herstellungsverfahren nach Anspruch 9, wobei vor dem Durchkontaktieren ein Schritt des Abdünnens des Siliziumwafer (W1; W1'; W1"; W1"') mit der Vielzahl von Halbleiterchips (SC1, SC2, SC3; SC2"; SC1"', SC2"'; SC3"') an der ersten rückseitigen Oberfläche (R1; R1'; R1"; R1"') durchgeführt wird.

## Claims

1. Production method for a micromechanical component, comprising the following steps:
providing a silicon wafer (W1; W1'; W1"; W1"') with a multiplicity of stars (SC1, SC2, SC3, SC2"; SC1"', SC2"', SC3"') wherein the silicon wafer has a first front-side surface (V1; V1', V1"; V1"') and a first rear-side surface (R1, R1', R1", R1"') ;
providing a high-grade steel wafer (W2; W2') with a corresponding multiplicity of carrier substrates (SS1, SS2, SS3, SS1"', SS2"', SS3"'), wherein the high-grade steel wafer has a second front-side surface (V2; V2"') and a second rear-side surface (R2; R2"');
applying a structured adhesion promoting layer (SG) to the first front-side surface (V1; V1'; V1"; V1"') and/or the second front-side surface (V2; V2"'), which has outgassing channels (SK, KG); aligning the first front-side surface (V1; V1'; V1"; V1"') and the second front-side surface (V2; V2"') according to a multiplicity of micromechanical components, each having a star (SC1, SC2, SC3; SC2"; SC1"', SC2"', SC3"') and a corresponding carrier substrate (SS1, SS2, SS3; SS1"', SS2"', SS3"') ;
connecting the first front-side surface (V1; V1' V1"; V1"') and the second front-side surface (V2; V2"') via the structured adhesion promoting layer (SG) with pressure being applied in such a way that each star (SC1, SC2, SC3; SC2"; SC1"', SC2"', SC3"') is connected to a corresponding carrier substrate (SS1, SS2, SS3; SS1"', SS2"', SS3"') according to a respective micromechanical component, wherein a gas from the ambient atmosphere can escape to the outside through the outgassing channels (SK, KG);
singulating the micromechanical components.

2. Production method according to Claim 1, wherein the silicon wafer (W1) is fashioned in such a way that the stars (SC1, SC2, SC3) are connected to a main wafer body (1) via one or a plurality of supporting regions (ST1, ST2) surrounded by a respective cavity (H1, H2).

3. Production method according to Claim 2, wherein the step of connecting comprises a thermal step, wherein the supporting regions (ST1, ST2) break and the main wafer body (1) is detached from the stars (SC1, SC2, SC3) as a result.

4. Production method according to Claim 1, wherein the silicon wafer (W1; W1', W1", W1"') is fashioned in such a way that the multiplicity of stars (SC1, SC2, SC3; SC2"; SC1"', SC2"', SC3"') is provided on a sawing film (SF; SF').

5. Production method according to Claim 1, wherein the high-grade steel wafer (W2; W2') is fashioned in such a way that the multiplicity of carrier substrates (SS1, SS2, SS3; SS1"', SS2"', SS3"') is connected by means of a carrier device (THE).

6. Production method according to any of the preceding claims, wherein the adhesion promoting layer (SG) is a seal glass layer that is heated to a temperature in the range of 100 to 500°C for connecting purposes.

7. Production method according to any of the preceding claims, wherein the adhesion promoting layer (SG) has a printed pattern having a multiplicity of separate structures (SGS) having first outgassing channels (SK), and wherein the separate structures (SGS) are separated by second outgassing channels (KG) .

8. Production method according to any of the preceding claims, the carrier substrates (SS1, SS2, SS3; SS1"', SS2"', SS3"') are steel substrates.

9. Production method according to any of the preceding claims, on the first front-side surface (V1; V1', V1", V1"') each star (SC1, SC2, SC3; SC2"; SC1"', SC2"', SC3"') has an integrated circuit (C1, C2; C1', C2'; C2"; C1", C2"') and the first front-side surface (V1; V1'; V1"; V1"') is connected to the second front-side surface (V2; V2"') via the structured adhesion promoting layer (SG) .

10. Production method according to Claim 9, wherein after the connecting and before the singulating, a step of through contacting of the stars (SC1, SC2, SC3; SC2"; SC1"', SC2"', SC3"') proceeding from the first rear-side surface (R1; R1'; R1"; R1"') is carried out.

11. Production method according to Claim 9, wherein before the through contacting, a step of thinning the silicon wafer (W1; W1', W1"; W1"') with the multiplicity of stars (SC1, SC2, SC3; SC2"; SC1"', SC2"', SC3"') at the first rear-side surface (R1; R1'; R1"; R1"') is carried out.

## Revendications

1. Procédé de fabrication d'un composant micromécanique comprenant les étapes suivantes :
préparation d'une plaquette de silicium (W1 ; W1' ; W1" ; W1"') comprenant une pluralité de puces semi-conductrices (SC1, SC2, SC3 ; SC2"; SC1"', SC2"' ; SC3"'), dans lequel la plaquette de silicium présente une première face avant (V1 ; V1' ; V1" ; V1"') et une première face arrière (R1 ; R1' ; R1" ; R1"') ;
préparation d'une plaquette d'acier inoxydable (W2 ; W2') comprenant une pluralité correspondante de substrats de support (SS1, SS2, SS3 ; SS1"', SS2"', SS3"'), dans lequel la plaquette d'acier inoxydable présente une deuxième face avant (V2 ; V2"') et une deuxième face arrière (R2 ; R2"') ;
application sur la première face avant (V1 ; V1' ; V1" ; V1"') et/ou la deuxième face avant (V2 ; V2"') d'une couche d'adhérence structurée (SG) présentant des canaux de dégazage (SK, KG) ;
alignement de la première face avant (V1 ; V1' ; V1" ; V1"') et de la deuxième face avant (V2 ; V2"') en correspondance avec une pluralité de composants micromécaniques qui présentent respectivement une puce semi-conductrice (SC1, SC2, SC3 ; SC2" ; SC1"', SC2"' ; SC3"') et un substrat de support (SS1, SS2, SS3 ; SS1"', SS2"', SS3"') correspondant ;
assemblage de la première face avant (V1 ; V1' ; V1" ; V1"') et de la deuxième face avant (V2 ; V2"') par l'intermédiaire de la couche d'adhérence structurée (SG) sous application de pression de manière à ce que chaque puce semi-conductrice (SC1, SC2, SC3 ; SC2" ; SC1"', SC2"' ; SC3"') soit reliée en correspondance avec un composant micromécanique respectif à un substrat de support (SS1, SS2, SS3 ; SS1"', SS2"', SS3"') correspondant, dans lequel un gaz de l'atmosphère environnante peut se dégager vers l'extérieur par l'intermédiaire des canaux de dégazage (SK, KG) ; séparation des composants micromécaniques.

2. Procédé de fabrication selon la revendication 1, dans lequel la plaquette de silicium (W1) est conçue de manière à ce que les puces semi-conductrices (SC1, SC2, SC3) soient reliées, par l'intermédiaire d'une ou de plusieurs zones de renfort (ST1, ST2) entourées par une cavité (H1, H2) respective, à un corps principal de plaquette (1).

3. Procédé de fabrication selon la revendication 2, dans lequel l'étape d'assemblage comprend une étape thermique, dans lequel les zones de renfort (ST1, ST2) se rompent et, de ce fait, le corps principal de plaquette (1) se détache des puces semi-conductrices (SC1, SC2, SC3).

4. Procédé de fabrication selon la revendication 1, dans lequel la plaquette de silicium (W1 ; W1' ; W1" ; W1"') est conçue de manière à ce que la pluralité de puces semi-conductrices (SC1, SC2, SC3 ; SC2" ; SC1"', SC2"' ; SC3"') soient disposées sur un film de sciage (SF ; SF').

5. Procédé de fabrication selon la revendication 1, dans lequel la plaquette d'acier inoxydable (W2 ; W2') est conçue de manière à ce que la pluralité de substrats de support (SS1, SS2, SS3 ; SS1"', SS2"', SS3"') soient reliés au moyen d'un dispositif de support (TE).

6. Procédé de fabrication selon l'une des revendications précédentes, dans lequel la couche d'adhérence (SG) est une couche de verre de scellement qui est chauffée à une température comprise entre 100 et 500°C pour l'assemblage.

7. Procédé de fabrication selon l'une des revendications précédentes, dans lequel la couche d'adhérence (SG) comprend un motif d'impression présentant une pluralité de structures séparées (SGS) avec des premiers canaux de dégazage (SK) et dans lequel les structures séparées (SGS) sont séparées par des deuxièmes canaux de dégazage (KG).

8. Procédé de fabrication selon l'une des revendications précédentes, dans lequel les substrats de support (SS1, SS2, SS3 ; SS1"', SS2"', SS3"') sont des substrats en acier.

9. Procédé de fabrication selon l'une des revendications précédentes, dans lequel chaque puce semi-conductrice (SC1, SC2, SC3 ; SC2" ; SC1"', SC2"', SC2"' ; SC3"') présente un circuit intégré (C1, C2 ; C1', C2' ; C2" ; C1"', C2"') sur la première face avant (V1 ; V1' ; V1" ; V1"') et la première face avant (V1 ; V1' ; V1" ; V1"') est reliée à la deuxième face avant (V2 ; V2"') par l'intermédiaire de la couche d'adhérence structurée (SG).

10. Procédé de fabrication selon la revendication 9, dans lequel, après l'assemblage et avant la séparation, une étape de métallisation des puces semi-conductrices (SC1, SC2, SC3 ; SC2"; SC1"', SC2"' ; SC3"') est effectuée en commençant par la première face arrière (R1 ; R1' ; R1" ; R1"').

11. Procédé de fabrication selon la revendication 9, dans lequel, avant la métallisation, une étape d'amincissement de la plaquette de silicium (W1 ; W1' ; W1" ; W1"') présentant la pluralité de puces semi-conductrices (SC1, SC2, SC3 ; SC2" ; SC1"', SC2"' ; SC3"') est effectuée sur la première face arrière (R1 ; R1' ; R1" ; R1"').
